# EUROPEAN PATENT APPLICATION

(11) **EP 1 582 270 A1**
(43) Date of publication of application: **05.10.2005**
(21) Application number: 04007735.6
(22) Date of filing: 31.03.2004
(51) Int. Cl.: B05D 3/14, B05D 7/24, H05H 1/24

(54) **Method and apparatus for coating a substrate using dielectric barrier discharge**

(71) Applicant: Vlaamse Instelling voor Technologisch Onderzoek, 2400 Mol (BE); Fraunhofer Gesellschaft, 80686 München (DE)
(72) Inventor: Rose, Klaus, 97318 Kitzingen (DE); Paulussen, Sabine Johanna Alouis, 2018 Antwerpen (BE); Rego, Robby Jozef Martin, 2440 Geel (BE); Havermans, Danny, 2340 Beerse (BE); Cools, Jan Jozef, 2490 Balen (BE); Vangeneugden, Dirk Leo, 3630 Maasmechelen (BE)
(74) Representative: Vandersteen, Pieter

(57) **Abstract**

There is described a method and apparatus for coating a substrate with an inorganic-organic hybrid polymer material. The method concerns generating and maintaining a plasma according to the Dielectric Barrier Discharge (DBD) technique, said method comprising the steps of introducing a sample in the space between two electrodes, generating a plasma discharge between the electrodes and admixing aerosols containing hybrid organic/inorganic cross-linked pre-polymers to the plasma discharge. There is also described an apparatus for generating the plasma and admixing the liquid coating material (precursor solution) in the form of aerosol to the plasma discharge.

## Description

The present invention relates to a method of coating a substrate material and materials so coated. In particular in one embodiment the method comprises atmospheric plasma curing of a hybrid polymer material..

In many applications the mechanical, chemical or physical properties of surfaces of materials play an important role. If, for any reason, the requirements can not be met by the bulk of the material, the application of coatings and surface modification is a convenient method in order to improve the properties. In this way many substrates can be refined and used in new applications. A very simple case is the refinement by coating with decorative and coloured layers. But in many cases and for special applications also other functional properties have to be improved, e. g. hardness, chemical resistance, electrical resistivity, barrier properties or optical appearance.

Increasing demands on new materials caused also growing interest in inorganic-organic hybrid materials with the potential to combine the inherent properties of inorganic materials with those of organic polymers as described in B. M. Novak, Adv. Mater. 5 (1993) 6. The classical approach has been the development of composite materials or blends, where at least two different phases with complementary properties were mixed. But since an optimised combination of properties can only be expected by a direct and optimised linkage between the two materials, the desired synergistic effects were not always achieved, due to incompatibility or phase separation.

A more powerful method in order to design new hybrid materials is the combination of inorganic and organic/polymeric structural units on a molecular scale by chemical synthesis. The sol-gel process has been established as a versatile method for the preparation of new inorganic-organic hybrid materials. It is described in for example : U. Schubert, N. Hüsing, A. Lorenz, Chem. Mater. 7 (1995) 2010 or C. J. Brinker, G. Scherer, Sol-Gel-Science, The Physics and Chemistry of Sol-Gel, Processing, Academic Press (1990).

Since the synthesis is carried out in aqueous/alcoholic media the resulting solution can be used as a lacquer in order to apply the hybrid material onto substrates for the improvement of the surface properties.

Inorganic-organic hybrid polymer coating materials (such as those avialable under the resgistered trade mark ORMOCER®s) allow a wide range of possible combinations and variations of inorganic and organic groups or structural elements and tailoring. And for this reason they are superior to commonly used organic coating materials.

Standard industrial coating technologies comprise the application of a lacquer followed by thermal or UV-induced curing treatment. In addition to these atmospheric pressure based techniques vacuum techniques like CVD, PVD or low pressure plasma are more and more used. Advantages of the ambient pressure methods are that they can be used with standard and inexpensive coating and curing equipment. Vacuum methods are often related to higher costs concerning equipment and processing and they give only very thin layers. Therefore, in metallisation processes and coating of small substrates, e.g. ophthalmic lenses, these methods have been established.

The following disadvantages of commonly used materials and technologies are evident:
Commonly used organic coating materials do not exhibit this high degree of cross-linking which is necessary for a high mechanical stability, scratch and abrasion resistance and for a high network density resulting in good barrier properties
In order to meet these requirements organic coatings have to be used with inorganic particles/fillers [4] or in multilayer compositions
Even hybrid materials exhibit high barrier properties only in multilayer compositions with SiOₓ or AlOₓ [5]

Thermal curing needs a long time at elevated temperatures in order to achieve effective crosslinking. High temperatures are harmful to a lot of commonly used plastic substrates and long curing times are disadvantageous for fast in-line production processes.
UV curing occurs mainly at the top of the coating. In the case of thick layers a decreasing degree of cross-linking into the depth of the layer is often observed
Low pressure plasma or CVD and PVD give highly cross-linked films but only thin layers in the nm range. This layer thickness is too low for excellent mechanical stability (scratch and abrasion resistance) or high barrier properties and the methods are too expensive for large scale applications

Classical curing methods do not utilize the full potential of the hybrid materials, whereas due to their low vapor pressure in the liquid phase they can not be used in vacuum techniques.

Therefore, atmospheric pressure plasma technology has been developed to circumvent the need for expensive and limited volume equipment of low pressure plasma. The use of this method in combination with hybrid polymer coating materials and their inherent properties is promising, since this synergistic effect will lead to coating materials with excellent and unique properties. It is an object of the invention to solve some of all of the problems with the prior art..

A method and apparatus for generating and maintaining a plasma is now described. When chemical compounds are introduced into a plasma discharge, chemically active species are formed such as molecules in excited states, radicals and ions. These species can react with each other, with neutral molecules or with the surface of a substrate. Depending on the nature of the compounds and the process conditions, this may result in cleaning, etching, chemical surface modification (often referred to as activation), deposition of a thin film (often referred to as plasma assisted coating deposition) or the formation of new chemical compounds in the form of gases, liquids or (nano sized) powders.

The type of plasma discharge wherein at least one electrode is covered by an electrically insulating material, is called "Dielectric Barrier Discharge" (DBD). Dielectric barrier discharges offer interesting perspectives for cost effective in-line plasma treatments. The configuration of a DBD apparatus generally comprises one or more sets of two electrodes of which at least one is covered with an insulating (dielectric) material. The equipment is especially interesting for innovative surface modification and coating deposition. For this purpose, various organic, inorganic or hybrid (organic/inorganic) precursors can be used. If not gaseous, these precursors are generally applied in the form of vapours of (heated) liquids, aerosols or (nano sized) particles.

The invention comprises the use of inorganic-organic hybrid polymers as liquid coating material (precursor solution) with an atmospheric aerosol assisted plasma process for film curing.

The principle of the formation of inorganic-organic hybrid polymers via sol-gel processing is the hydrolysis and condensation of organically functionalized alkoxysilanes. The sol-gel synthesis of precursor solutions is outlined below. 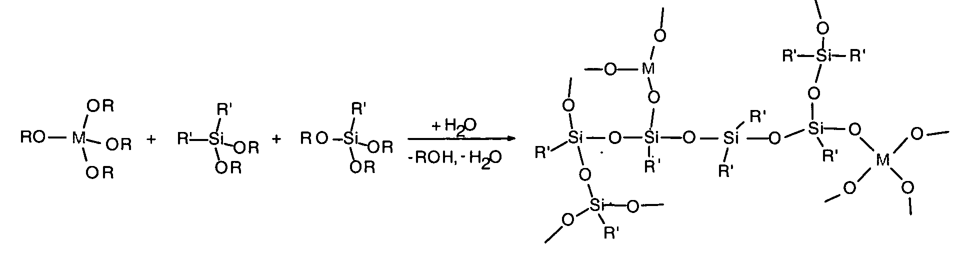 where R' = non-reactive/functional or reactive/polymerizable group, R = Me, Et, M = Si, Ti, Zr...

As a result of this reaction an inorganic, silica-like network or silicone-like chain as prepolymer is formed bearing functional organic groups R'.

The combination of organically substituted alkoxysilanes with alkoxy compounds of metals, e.g. Si(OEt)₄, Ti(OEt)₄, Zr(OPr)₄, Al(O^{s}Bu)₃ will modify the inorganic part of the material by formation of the corresponding metal oxide structure. In this way very hard and highly densified materials are available which can be used as scratch resistant or barrier coatings.

Examples of precursors for the formation of a pure inorganic glass-like or ceramic-like network are as follows:

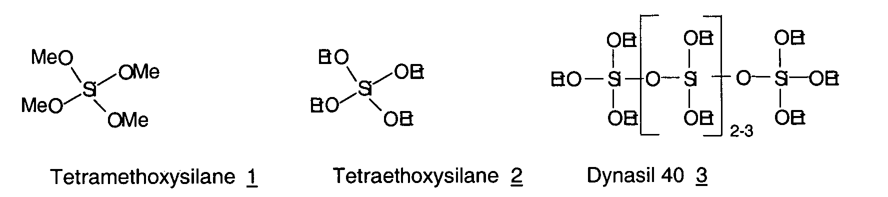

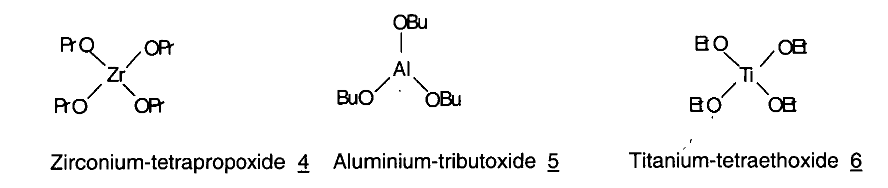

The monomer compounds for the formation of a pure inorganic network may bear an organic complex ligand like acetic acid ethyl ester or methacrylic acid:

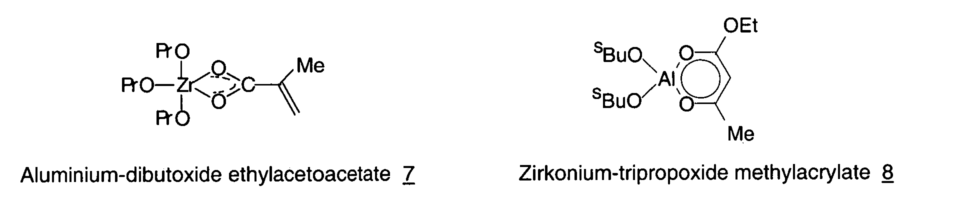

It is also possible to use an oligomer siloxane as inorganic crosslinker:

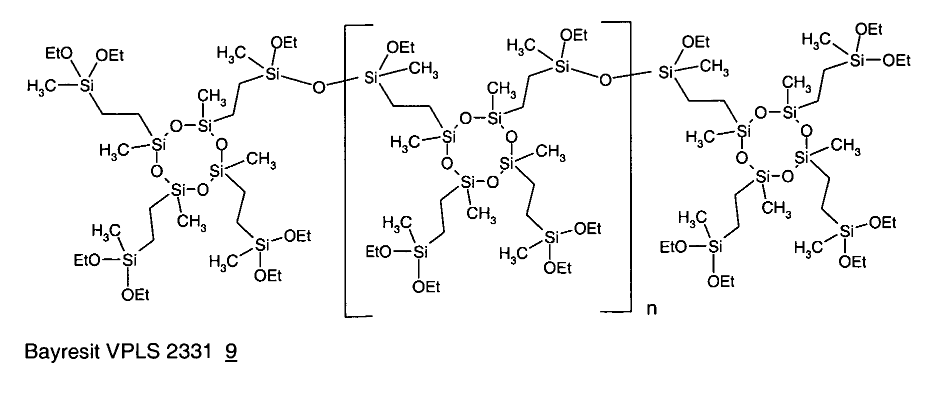

Non-reactive groups R' act as network modifiers suitable for network functionalisation in order to introduce chemical properties to the coating. Examples of organically functionalised alkoxysilanes are given below:

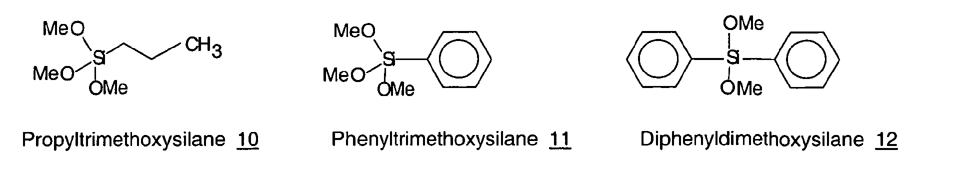

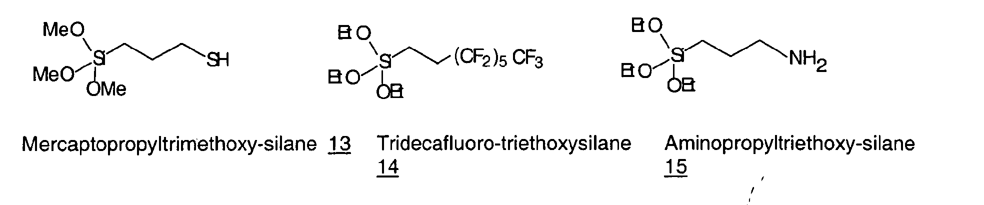

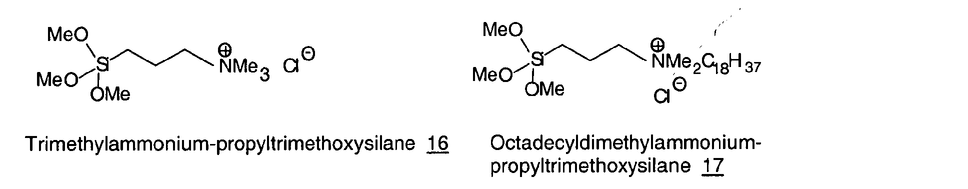

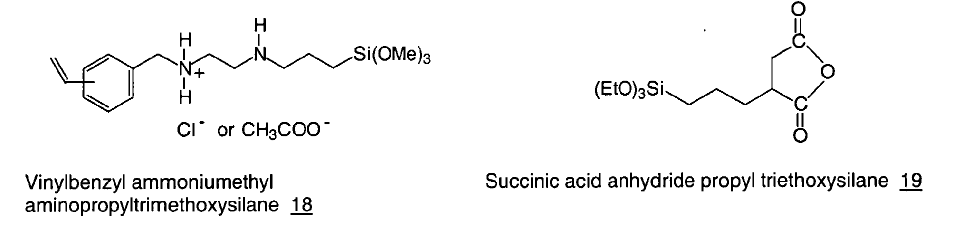

In the case of reactive groups R' an additional organic polymer network can be formed by polymerization reactions of the reactive groups. Examples of monomer silanes with reactive groups are as follows:

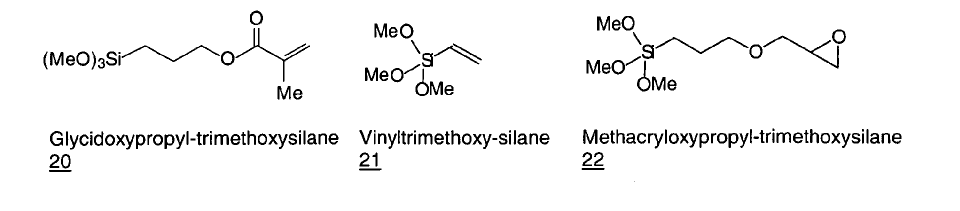

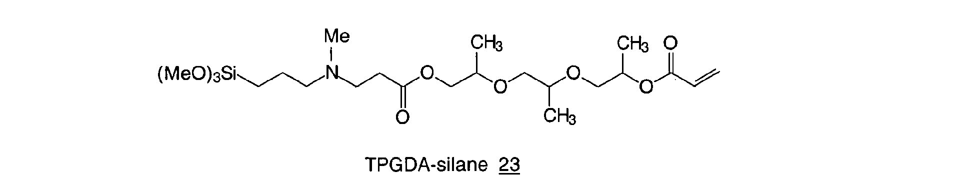

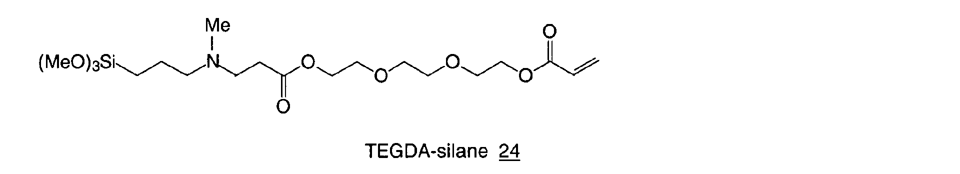

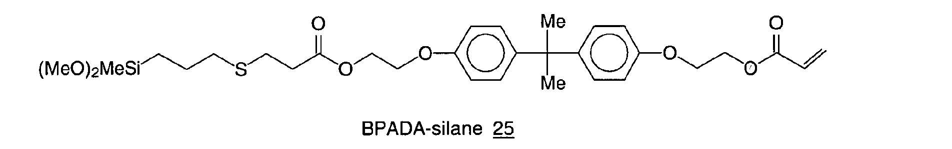

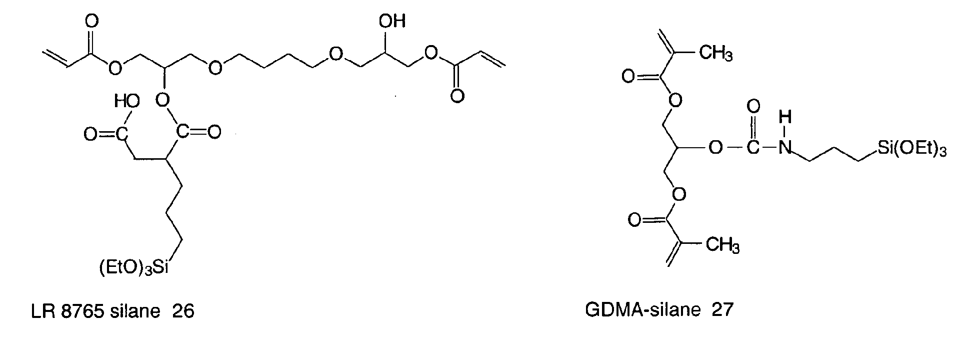

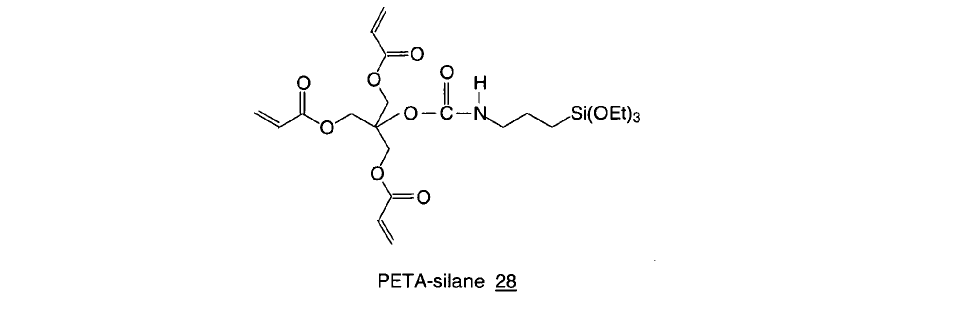

In the method of the invention one or more of the following compounds may be added to the mixture of cross-linked inorganic-organic hybrid pre-polymer used in the sol-gel system before aerosol formation:
organic coating forming materials; optionally carboxylates, methacrylates, acrylates, styrenes, methacrylonitriles, alkenes and dienes, more optionally methyl (meth)acrylate, ethyl (meth)acrylate, propyl (meth)acrylate, butyl (meth)acrylate and/or other alkyl (meth)acrylates, organofunctional (meth)acrylates, glycidyl methacrylate, trimethoxysilyl propyl methacrylate, allyl methacrylate, hydroxyethyl methacrylate, hydroxypropyl methacrylate, dialkylaminoalkyl methacrylates, andfluoroalkyl (meth) acrylates, methacrylic acid, acrylic acid, fumaric acid and esters, itaconic acid (and esters), maleic anhydride, styrene, α-methylstyrene, halogenated alkenes, for example, vinyl halides, such as vinyl chlorides and vinyl fluorides, and fluorinated alkenes, for example perfluoroalkenes, acrylonitrile, methacrylonitrile, ethylene, propylene, allyl amine, vinylidene halides, butadienes, acrylamide, such as N-isopropylacrylamide, methacrylamide, epoxy compounds, for example glycidoxypropyltrimethoxysilane, glycidol, styrene oxide, butadiene monoxide, ethyleneglycol diglycidylether, glycidyl methacrylate, bisphenol A diglycidylether (and its oligomers), vinylcyclohexene oxide and phosphorus-containing compounds, for example dimethylallylphosphonate. Additional inorganic coating forming materials which can be added include colloidal metals and metal oxides and organometallic compounds.

In the method of the invention the inorganic-organic hybrid coating may be obtained and/or obtainable by mixing separately in additional to the aerosol in step d) one or more additional gases, vapours, aerosols or powders of the following compounds to the plasma discharge: Ar, He, O₂, N₂, CO₂, CO, SF₆, NO, NO₂, N₂O, H₂, methane, ethane, propane, butane, ethylene, propylene, ethylene oxide, propylene oxide, acetylene, CF₄, C₂F₆, C₂F₄, H₂O and/or or any of the ingredients described herein.

Under plasma conditions radicals are generated. Radicals are known to initiate the polymerization of vinyl-, methacryl- or acryl double bonds as well as bond cleavage or ring opening reactions. The radical fragments formed by the latter mechanisms are also able to polymerize and recombine thus also forming an organic network.

Coatings obtained from alkoxysilane precursors with reactive acrylic or epoxy groups showed similar results after plasma and UV-curing (acrylics) or thermal curing (epoxide), respectively. Spectroscopic data indicate that atmospheric plasma also initiates radical polymerization (acrylics) or ring opening and polymerization (epoxide) as it is known from conventional curing.

Coatings from precursors with non-reactive aliphatic groups, were tack-free and solid after plasma processing, whereas after thermal curing they were still sticky. This result and spectroscopic data indicate that organic cross-linking probably via fragmentation and chain formation as well as inorganic (siloxane-) network formation occur simultaneously during the plasma process.

Polymers functionalised to be suitable for use in the present invention (for example those sold under the trade mark ORMOCER®) may be synthesised as follows:
the polymer is silylated with suitable alkoxysilane monomer(s);
the silylated polymers undergo a sol-gel-reaction with functional silane precursors to form a solution of an inorganic-organic hybrid polymer whihc can be used as described herein in the plasma process. The reaction is shown schematically below 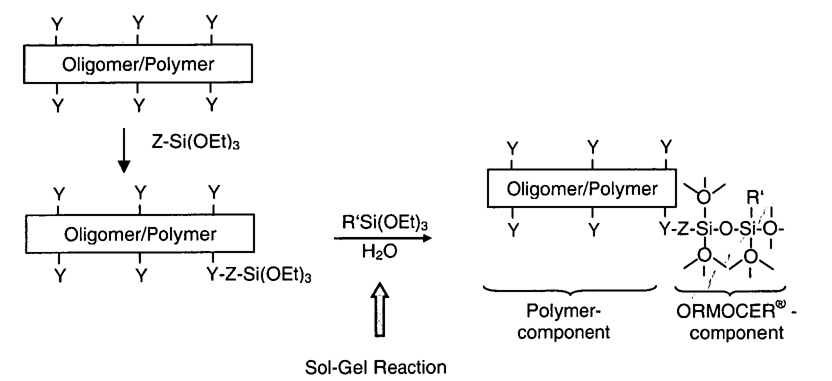 where Y denotes a functional group on the polymer to be used for reaction with a functional group on the alkoxysilanes for the modification/silylation of the polymer;
   Z: denotes a functional group for attaching the alkoxysilane to the polymer; and
   R':denotes a non reactive/functional or reactive polymerizable group.

Some preferred reactions for linking silane monomers to polymers are:

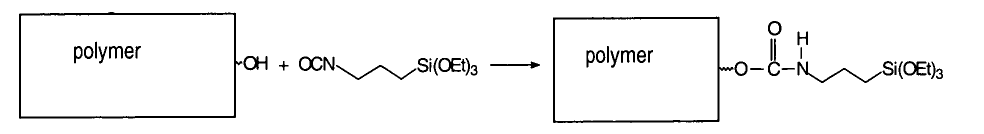

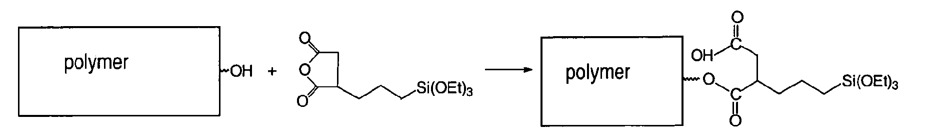

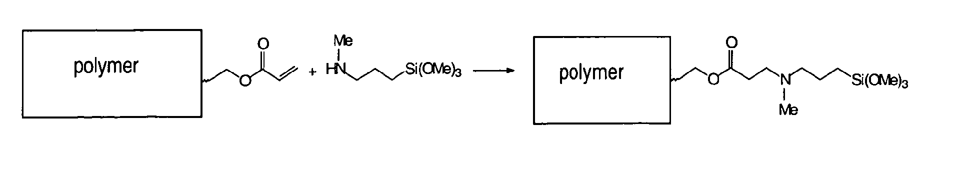

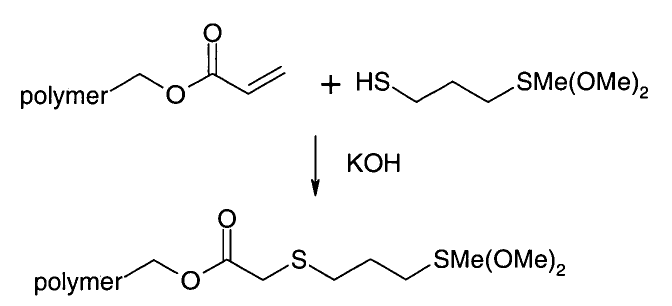

Other preferred reactions are epoxy groups with amino groups to form polymer-epoxy with amino silane groups or vice versa.

As used herein (meth)acrylate denotes methacrylate and acrylate moities.

The methods described herein have the advantage that the polymers to be functionalised can be selected to have the desired inherent properties (such as flexibility, conductivity, hydrophilicity) which after functionalisation are then introduced into the hybrid material.

The process includes the injection of the film forming precursor as an aerosol via atomization into the plasma volume adjacent to the base substrate (Aerosol Assisted Atmospheric Plasma: AAAP). The influence of the plasma on the aerosol droplets of the coating material will enhance their reactivity thus improving cross-linking and curing results. Limitations due to film thickness are also reduced. This effect can be additionally improved by decreasing the size of the droplets to the nano-scale. A nano-sized aerosol will be generated by an electrospray process which offers control on aerosol diameter and charge.
The combination of the plasma process with designed hybrid polymers increases the performance of the resulting coatings significantly regarding curing behavior, degree of cross-linking and network density. In combination with the possibility of chemical functionalization of ORMOCER®s the field of applications of these materials can be extended significantly. Moreover, the plasma can also have effects on functionalization of coatings and on adhesion.

It has been shown that plasma curing affects both inorganic and organic cross-linking in the hybrid polymer precursors. This twofold effect of the plasma process both on organic and inorganic components of hybrid coating materials is superior to that of conventional curing with respect to the degree of cross-linking and network density.

Coatings manufactured by the novel AAAP process in combination with hybrid coating materials used in an in-line production environment will exhibit better performance and increased functionality at reduced costs. Enhanced network density will increase particularly the mechanical stability and barrier properties of the produced films.

The process is not limited to specific kinds of substrate materials.

In the patent WO 02/28548 A2 an ambient pressure plasma process is described in combination with monomer alkoxysilanes of the general type R'Si(OEt)₃ and other organic monomers. The alkoxysilanes are used as monomers, i.e. without hydrolysation and without the formation of an inorganic prepolymer. The difference to the method described here is obvious and significant. When using monomers the degree of crosslinking is lower than in the case of prepolymers. And a high degree of crosslinking is necessary for high performance materials.

In another aspect of the present invention there is provided a method for generating and maintaining a plasma according to the Dielectric Barrier Discharge (DBD) technique, said method comprising the steps of :
a)- introducing a sample in the space between two electrodes,
b)- controlling the atmosphere between the electrodes,
c) generating a plasma discharge between the electrodes
d)- admixing aerosols containing hybrid organic/inorganic cross-linked pre-polymers to the plasma discharge

According to the invention, said plasma can be maintained at a pressure in the range between 100Pa and 1MPa. According to a further embodiment, said plasma is maintained at a pressure in the range between 1000Pa and 1 MPa, preferably at atmospheric pressure.

Said atmosphere may additionally comprise one or more of the following components : gases, vapours, aerosols, powders. Said mixed atmosphere may exhibit a compositional gradient.

The invention is equally related to an apparatus for generating and maintaining a plasma, preferably in the pressure range between 100Pa and 1 MPa, said apparatus comprising a pair of electrodes, a gap being present between said electrodes, and a voltage generator for applying a voltage between said electrodes, said electrodes consisting of an electrically conducting material, wherein one or both electrodes are covered with an electrically insulating material, characterized in that said generator is capable of generating an alternating voltage such as described herein. Furthermore, one or both electrodes may be temperature controlled and one or both of the electrodes may be movable.

In an apparatus of the invention, said electrodes may have the form of planar or curved plates or grids, bars, cylinders, or knife or brush type geometries. One or both of said electrodes may be segmented in different parts of any shape. An apparatus of the invention may comprise a parallel and/or serial combination of one or more of said electrodes.

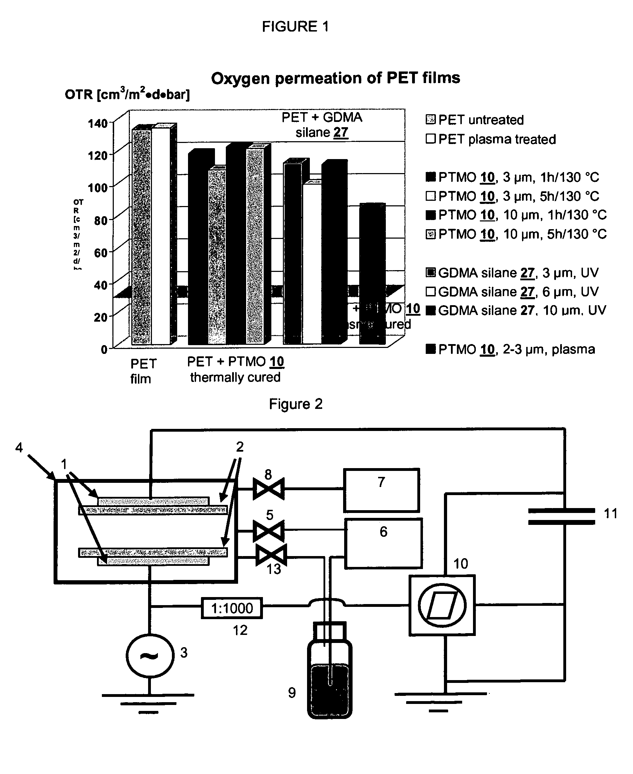

An embodiment of an apparatus in which the method according to the invention can be implemented is depicted in Figure 2. The apparatus (4) comprises a pump (7) to evacuate the gases, with a optional control valve (8). An inlet port with an optional control valve is provided both for the gases (5) coming from a gas supply unit (6) and the aerosols of hybrid organic/inorganic cross-linked prepolymers 13 coming from an aerosol generator 9. The apparatus also comprises at least one set of electrodes (1 and 2). The power supply (3) is connected to at least one of the electrodes. The other electrode can be grounded, connected to the power supply (3) or connected to a second power supply. Voltage, charge and current measurements can be performed by means of an oscilloscope (10). For this one can use respectively a voltage probe (12), a capacitor (11) and a current probe.

Any known generator capable of delivering a high voltage having a symmetrical or asymmetrical profile, can be used. Suitable generator are for example provided by Corona Designs.

Such an apparatus further comprises a pair of electrodes, a gap being present between the electrodes, wherein a mixed atmosphere is to be arranged in said gap.

The electrodes consist of an electrically conducting material and said electrodes can be constructed in any shape but preferentially will take the form of planar or curved plates or grids, bars, cylinders, knife or brush type geometries. One or both of said electrodes consists of an electrically conducting material covered with an electrically insulating material. Furthermore, one or both of said electrodes may be segmented in different parts of any shape. An apparatus of the invention may comprise a parallel and / or serial combination of one or more of said electrodes.

In an apparatus of the invention, at least one material may be placed between said electrodes. Said material can be a sample requiring a plasma treatment. Said sample can be an organic, inorganic or metallic foil, plate, fibre, wire or powder, a woven or non-woven textile or any combination thereof.

The plasma treatment conditions at each of the electrode surfaces and at the surfaces of any material placed between the electrodes can differ substantially from each other and can be controlled by the characteristics of the alternating current voltage applied to these electrodes.

The plasma treatment conditions can consist of any combination of following operations: etching, cleaning, activation or deposition.

One or both electrodes in an apparatus of the invention may be temperature controlled. Furthermore, one or both of the electrodes may be movable.

Further aspects and/or preferred features of the invention are described in the claims.

By way of illustration only the following non-limiting examples are described, with reference to the numbered compounds previously.

Hybrid coatings based on precursor compounds bearing reactive or non-reactive groups were deposited by the AAAP process and compared with conventionally cured coatings.

After plasma treatment as well as after thermal curing (1h/100-200 °C) a precursor solution of **2** resulted in powder formation. This means that inorganic cross-linking due to condensation reaction is evident, also in plasma curing. In sol-gel derived systems this process is known to start only at higher temperatures with a duration in the range of hours. In the case of plasma curing this effect is remarkable since the plasma exposition occurs for several minutes at a lower temperature.

Transparent and homogeneous coatings were obtained from solutions of hydrolized **20** and **22** after plasma curing. In both cases organic cross-linking (**20****:** ring opening and polymerization, **22****:** radical initiated -C=C-polymerization) and inorganic cross-linking /condensation has occurred. The organic cross-linking/polymerization was observed via IR-spectroscopy. The spectra of **20** exhibit the formation of a carbonyl indicating the ring opening reaction. The spectra of **22** show a significant decrease of the -C=C-double bond (1640 cm⁻¹) indicating organic polymerization. The results are similar to those which have been obtained after thermal curing **(****20**:1 h/130 °C) and UV curing, respectively **(****22****:** 20 s and 5,93 J/cm² ).

In **10** no reactive organic polymerizable group is present, i. e. only condensation reactions are possible, in principle. The films obtained after plasma treatment were cured, whereas after thermal curing (1-5 h/130°C) the films were still sticky, i. e. not cured. This effect shows clearly that after thermal treatment only condensation has occurred, which is not as effective as in **2****.** During plasma curing additional organic cross-linking has occurred leading to cured films as shown by IR spectroscopy. The IR spectrum of thermally cured **10** is identical to the non-cured film, whereas the spectrum of plasma cured **10** exhibits a carbonyl signal at 1695 cm⁻¹ indicating also oxidation reaction in the organic chain.

In order to confirm the effect of plasma curing on macroscopic properties, the oxygen permeability of coated PET films was determined. As can be seen in Figure 2, the oxygen permeability decreases significantly from thermally cured **10** and UV cured **27** to plasma cured **10** coatings on PET films. The reason is the highly densified structure obtained only with plasma curing.

## Claims

1. A method for coating a substrate with an inorganic-organic hybrid polymer material using the Dielectric Barrier Discharge (DBD) technique, said method comprising the steps of:
a) introducing a sample in the space between two electrodes,
b) controlling the atmosphere between the electrodes,
c) generating a plasma discharge between the electrodes,
d) mixing aerosols containing hybrid organic/inorganic cross-linked pre-polymers into the plasma discharge

2. A method as claimed in claim 1, in which one or more of the following additional components may be added to the plasma discharge: gases, vapors, aerosols or powders of non cross-linked precursor chemicals.

3. A method as claimed in either preceding claim in which the aerosol in step d) comprises a compositional gradient of the pre-polymers and/or any optional additional admixed components.

4. A method as claimed in any preceding claim, in which the plasma is maintained at a pressure from about 100Pa to about 1 MPa, optionally from about 1 kPa to about 1MPa , more optionally at about atmospheric pressure.

5. A method as claimed in any preceding claim, where the plasma is generated by alternating voltage between the electrodes of a frequency from about 10Hz to about 50MHz.

6. A method as claimed in any preceding claim, where the substrate comprises plastic, non-woven or woven fibers, natural, synthetic or semi-synthetic fibers, cellulosic material, metal, ceramic, powder or any composite structure thereof.

7. A method as claimed in any preceding claim, where the hybrid inorganic-organic coating increases, decreases and/or controls one or more of the following physical properties compared to the uncoated substrate: hydrophilic, hydrophobic, oleophilic, oleophobic, adhesive, release, gas diffusion barrier, liquid diffusion barrier, solids diffusion barrier, chemical resistance, UV resistance, thermal resistance, flame retardancy, porosity, conductivity, optical, self cleaning, acoustic, roughness, wear resistant, scratch resistant, lubricating, antimicrobial, biocompatible, sensory, catalytic, humidity, drug release, softness to touch, taste, smell, insect repelling, allergic reaction, toxicity, acid-base level.

8. A method as claimed in any preceding claim, in which the coating is an inorganic-organic hybrid polymer obtained and/or obtainable from an aerosol containing cross-linked inorganic-organic hybrid pre-polymer.

9. A method as claimed in any preceding claim" in which the inorganic-organic hybrid prepolymer is obtained and/or obtainable from one or more of:. Tetramethoxysilane; Tetraethoxysilane; Dynasil 40; Zirconium-tetrapropoxide; Aluminium-tributoxide Titaniumtetraethoxide; Aluminium-dibutoxide ethylacetoacetate; Zirkonium-tripropoxide methylacrylate; Bayresit VPLS 2331 ; Propyltrimethoxysilane; ;Phenyltrimethoxysilane; Diphenyldimethoxysilane; Mercaptopropyltrimethoxy-silane; Tridecafluoro-triethoxysilane; Aminopropyltriethoxy-silane; Trimethylammonium-propyltrimethoxysilane; Octadecyldimethylammonium-propyltrimethoxysilane; Vinylbenzyl ammoniumethyl aminopropyltrimethoxysilane; Succinic acid anhydride propyl triethoxysilane; Glycidoxypropyltrimethoxysilane; Vinyltrimethoxy-silane; Methacryloxypropyl-trimethoxysilane; TPGDA-silane; TEGDA-silane; BPADA-silane; LR 8765 silane; GDMA-silane and/or; PETA-silane, silylated polymers and/or suitable mixtures thereof.

10. A method as claimed in any preceding claim, where the pre-polymer mixture in step d) further comprises: colloidal metals and metal oxides, organometallic compounds and/or organic coating forming materials; optionally selected from carboxylates, (meth)acrylates, styrenes, methacrylonitriles, alkenes and/or dienes, (meth)acrylic acid, fumaric acid (and esters), itaconic acid (and esters), maleic anhydride, halogenated alkenes, (metha)acrylonitrile, ethylene, propylene, allyl amine, vinylidene halides, butadienes, (meth)acrylamide, epoxy compounds, styrene oxide, butadiene monoxide, ethyleneglycol diglycidylether, glycidyl methacrylate, bisphenol A diglycidylether (and its oligomers), vinylcyclohexene oxide and phosphorus-containing compounds and/or any suitable mixtures thereof.

11. A method as claimed in any preceding claim, in which the inorganic-organic hybrid coating is obtained and/or obtainable by mixing separately in additional to the aerosol in step d) one or more additional gases, vapours, aerosols or powders of the following compounds to the plasma discharge: Ar, He, O₂, N₂, CO₂, CO, SF₆, NO, NO₂, N₂O, H₂, methane, ethane, propane, butane, ethylene, propylene, ethylene oxide, propylene oxide, acetylene, CF₄, C₂F₆, C₂F₄, H₂O and/or or any of the ingredients described in claim 10 .

12. A method as claimed in any preceding claim, in which the coating is applied as a liquid precursor.

13. A method as claimed in any preceding claim, in which the substrate which is coated is selected from, a powder, wire and/or an optional moving material web.

14. A coated substrate obtained and/or obtainable by a method as claimed in any preceding claim.

15. An apparatus for generating and maintaining a plasma for use in a method as claimed in any of claims 1 to 13; the apparatus comprising a pair of electrodes, a gap being present between said electrodes, and a voltage generator for applying a voltage between said electrodes, said electrodes consisting of an electrically conducting material, wherein one or both electrodes are covered with an electrically insulating material, and where thee generator is capable of generating an alternating voltage a frequency from about 10Hz to about 50 MHz.

16. The apparatus according to claim 15, where said electrodes have the form of planar or curved plates or grids, bars, cylinders, or knife or brush type geometries.

17. The apparatus according to claim 15 or 16 where one or both of said electrodes is segmented in different parts of any shape.

18. The apparatus according to any one of claims 15 to 17, comprising a parallel and/or serial combination of one or more of said electrodes.

19. The apparatus according to any one of claims 15 to 18, where one or both electrodes are temperature controlled.

20. The apparatus according to any one of claims 15 to 19, where one or both of the electrodes is movable.
